Europäisches Patentamt

European Patent Office

Office européen des brevets

(11) Publication number: **0 239 187 B1**

(12) **EUROPEAN PATENT SPECIFICATION**

(45) Date of publication of patent specification: **22.04.92** (51) Int. Cl.⁵: **G11C 11/401**

(21) Application number: **87300484.0**

(22) Date of filing: **21.01.87**

(54) **Semiconductor memory device.**

(30) Priority: **30.01.86 JP 20614/86**

(43) Date of publication of application:
**30.09.87 Bulletin 87/40**

(45) Publication of the grant of the patent:
**22.04.92 Bulletin 92/17**

(84) Designated Contracting States:
**DE FR GB**

(56) References cited:
**EP-A- 0 057 784**

(73) Proprietor: **MITSUBISHI DENKI KABUSHIKI KAISHA**
**2-3, Marunouchi 2-chome Chiyoda-ku**
**Tokyo 100(JP)**

(72) Inventor: **Furutani, Kiyohiro c/o Mitsubishi Denki K.K.**
**LSI Kenkyusho 1, Mizuhara 4-chome**
**Itami-shi Hyogo-ken(JP)**
Inventor: **Arimoto, Kazutami c/o Mitsubishi Denki K.K.**
**LSI Kenkyusho 1, Mizuhara 4-chome**
**Itami-shi Hyogo-ken(JP)**
Inventor: **Mashiko, Koichiro c/o Mitsubishi Denki K.K.**
**LSI Kenkyusho 1, Mizuhara 4-chome**
**Itami-shi Hyogo-ken(JP)**

(74) Representative: **Barnard, Eric Edward et al**
**BROOKES & MARTIN High Holborn House**
**52/54 High Holborn**
**London WC1V 6SE(GB)**

Rank Xerox (UK) Business Services

# Description

The present invention relates to a semiconductor memory device and particularly to a device with memory cells configured for a high level of integration.

## BACKGROUND TO THE INVENTION

A semiconductor memory device of the type with which the present invention is concerned was proposed in lecture number FAM I7.4 of ISSCC 85 and is described in more detail hereinafter. Although this type of device decreases the planar areas needed for the creation of the data charge storage capacitance of the memory cells the configuration still imposes a limitation on the degree of integration.

A general object of the present invention is to provide an improved semiconductor memory device and memory cell configuration.

## SUMMARY OF THE INVENTION

According to the invention, there is provided a semiconductor memory device comprising:

a plurality of memory cells arranged in rows and columns to form a matrix,

a first bit line to which memory cells of a first column are connected, each of the memory cells of the first column comprising an N-channel FET and capacitance means,

a second bit line to which memory cells of a second column are connected, each of the memory cells of the second column comprising a P-channel FET and capacitance means and a word line connected to the gate of the N-channel FET of one of the memory cells of the first column and to the gate of the P-channel FET of one of the memory cells of the second column. During use, the first bit line and the second bit line are connected to complementary terminals of a sense amplifier to form a folded-bit line pair and the word line provides different voltage levels to select the cells.

The device is preferably associated with means selectively providing the word line with a first voltage to make conductive the N-channel FET connected thereto and to make nonconductive the P-channel FET connected thereto, or a second voltage to make conductive the P-channel FET connected thereto and to make nonconductive the N-channel FET connected thereto, or a third voltage to make nonconductive both the N-channel FET and the P-channel FET connected thereto.

Each word line can thus be shared by two rows of cells and a semiconductor memory device constructed in accordance with the invention avoids the restriction imposed on high level integration with the prior art.

## BRIEF DESCRIPTION OF THE DRAWINGS

The invention may be understood more readily, and the features of the invention may become apparent from consideration of the following description, in conjunction with the accompanying drawings, wherein:-

Fig. IA is a plan view of a part of a conventional semiconductor memory device;

Fig. IB is a cross-section along the line X-X′ of Fig. IA;

Fig. 2 is a plan view showing a part of a semiconductor memory device constructed in accordance with the invention; and

Fig. 3 is a circuit diagram depicting how the memory cells of the device of Fig. 2 are connected.

An example of a highly integrated dynamic semiconductor memory device of the type proposed in the lecture number FAM I7.4 of ISSCC 85 is shown in Figs. IA and IB. As illustrated, the device comprises a p-type semiconductor substrate I, a field oxide film 2 at the base of an isolation trench in the substrate, a first poly-silicon layer 3 overlying the film 2, a capacitor insulating film 4 at one of the sides of the trench, and an $n^+$ diffusion layer 5 in the flat portion of the substrate I. A first Al interconnection layer 6 forms bit lines. A second poly-silicon layer 7 and a second Al layer 8 forms word lines 9. Although not illustrated as such, the second poly-silicon layer 7 is electrically connected at regular intervals with the second Al interconnection layer 8 to reduce the effective resistance of the word lines 9. Contact holes I0 serve for electrical connection of the first Al interconnection layer 6 to the $n^+$ diffusion layer 5. Cp represents a data charge storage capacitance formed from the poly-silicon layer 3 and the $n^+$ diffusion layer 5 on one of the respective sides of the trench isolated by the capacitor insulating film 4. Cf represents a data charge storage capacitor formed of the poly-silicon layer 3 and the $n^+$ diffusion layer 5 on the flat part of the substrate I.

By utilizing one of the sidewalls of the isolation trench to form the data charge storage capacitance Cp, the area needed for the data charge storage capacitance Cf on the flat part of the substrate I is reduced. As a result, any reduction in the overall chip area does not necessarily lead to a reduction in the operational characteristics and the data charge storage capacitance can be secured against minority carriers injected because of external influences e.g. radiation such as alpha particles. As the periphery of the memory cells is lengthened, the trench may be made shallower in order to maintain the same collective data charge storage capacitance Cp + Cf. In a conventional highly-integrated dynamic semiconductor memory of a folded-bit line configuration and having the above-described memory cells in which data charge storage capacitance are partly formed on the sidewalls of the isolation trenches (Cp), the area necessary for forming each memory cell (for one bit) is equivalent to the area of half a contact hole (because one contact is shared by two memory cells) and the area for two word lines. Thus, if the area for the data charge storage capacitance Cp on the sidewalls of the isolation trenches is increased by forming deeper isolation trenches thereby to reduce the data charge storage capacitances Cf on the flat part of the substrate and increase the degree of integration, it then becomes difficult to establish adequate area to accommodate two word lines. Thus, a serious restriction on the design is imposed.

## DETAILED DESCRIPTION OF THE PREFERRED EMBODIMENTS

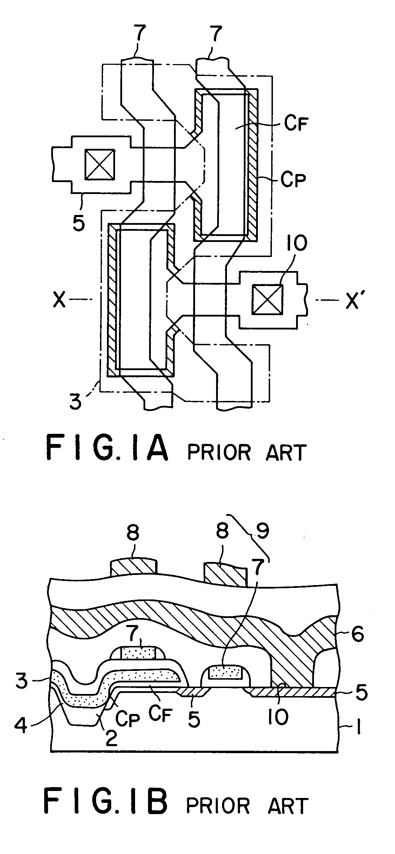

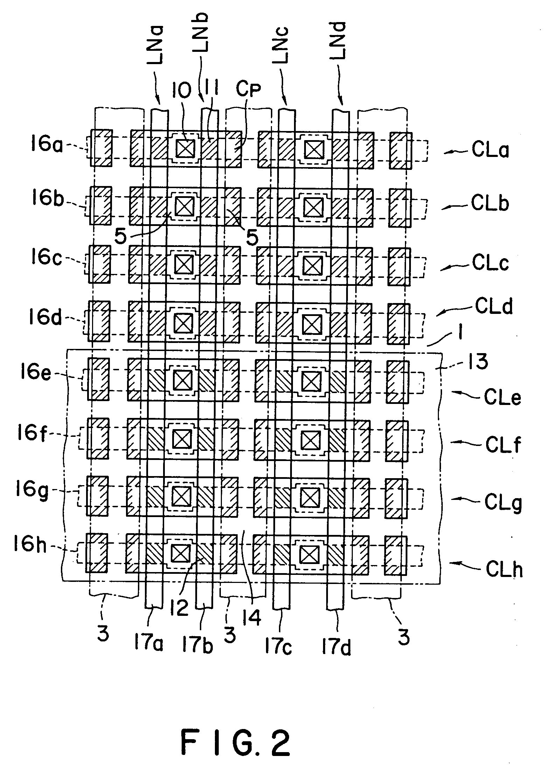

Fig. 2 shows a part of a semiconductor memory device representing an embodiment of the invention and the same reference numerals are used as in Figs. IA and IB to denote identical or similar structures. As illustrated, isolation trenches I4 are formed to surround each pair of memory cells sharing a contact hole I0. The memory cells have MOSFETs with channel parts II or I2, and storage capacitors formed at least partially of the capacitances Cp on the sidewalls of the isolation trenches I4. As illustrated, the memory cells are arranged, in columns which extend horizontally as viewed in Fig. 2. Only some of the columns CLa through CLh are illustrated, and they are shown to be respectively associated with bit lines I6a through I6h. The memory cells of each column are all connected to the associated bit line (e.g., one of the bit lines I6a through I6h) through the contact holes I0.

The memory cells of some of the columns, such as CLa through CLd, each comprise an N-channel MOSFET having the channel part II formed directly on the P-type substrate I, while the memory cells of some of the columns, such as CLe through CLh, each comprise a P-channel MOSFET having the channel part I2 formed on an n-well or tub I3 in the P-type substrate I.

In the embodiment illustrated, the memory cells of four adjacent columns comprise N-channel MOSFETs, and the memory cells of the next four columns comprise P-channel MOSFETs, and so on in alternation. In other words, the conductivity type of the MOSFETs of the memory cells is alternated every four columns. The number of columns with N-channel and P-channel MOSFETs may be some other number than four. In the region where the N-channel MOSFETs are formed, each of the data charge storage capacitances Cp is formed of the $n^+$ diffusion layer 5 and the poly-silicon layer 3 on the sidewall of the isolation trench I4. In the region where the P-channel MOSFETs are formed, each of the data charge storage capacitances Cp is formed of a p+ diffusion layer and the poly-silicon layer 3 on the sidewall of the isolation trench I4.

Memory cells are also arranged in lines orthogonal to the columns. Only some of the lines LNa through LNd are illustrated, and they are shown to be respectively associated with word lines I7a through I7d. The gates of the MOSFETs of the memory cells of each line are all connected to the associated word line (e.g., one of the word lines I7a through I7d).

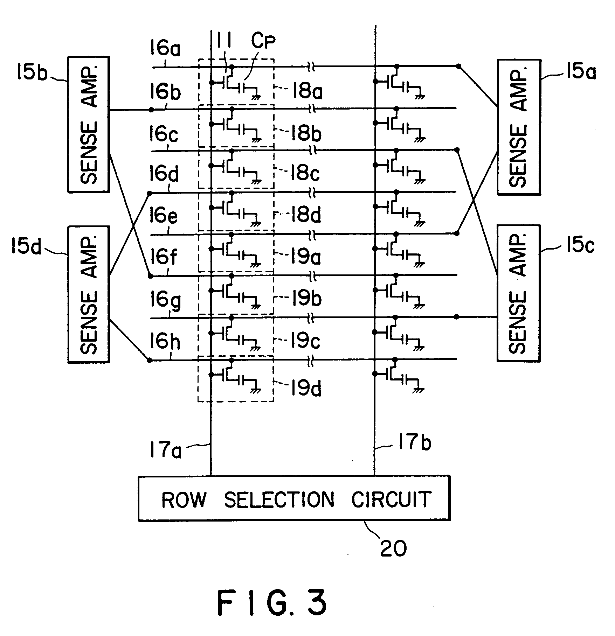

Fig. 3 depicts the electrical connection of the memory cells, together with sense amplifiers I5a through I5d. As illustrated, pairs of bit lines I6a, I6e; I6b, I6f; I6c, I6g; and I6d, I6h are respectively connected to the complementary data terminals of the sense amplifiers I5a through I5d to form a folded-bit line configuration. In Fig. 3, the memory cells in the line LNa are shown in detail and they are denoted by reference numerals I8a through I8d and I9a through I9d. The memory cells I8a through I8d are the ones comprising N-channel MOSFETs, while the memory cells I9a through I9d are the ones comprising P-channel MOSFETs. The N-channel MOSFETS are of the enhancement type and have a positive threshold voltage, e.g., 4V. The P-channel MOSFETs are of the enhancement type and have a negative threshold voltage, e.g., -4V.

The word lines I7a through I7d are connected to a row selection circuit 20. The row selection circuit 20 provides each of the word lines I7a through I7d with i) a first voltage enabling, i.e. making conductive, all the N-channel MOSFETs connected thereto and disabling i.e. making nonconductive all the P-channel MOSFETs connected thereto, ii) a second voltage making conductive all the P-channel MOSFETs connected thereto and making nonconductive all the N-channel MOSFETs connected thereto, or iii) a third voltage making nonconductive all the N-channel and P-channel MOSFETs connected thereto.

Where the "H" level as stored in the data charge storage capacitances Cp is at 5V, and the "L" level as stored in the data charge storage capacitances Cp is at 0V, the above mentioned first, second, third voltages are for example 9V, -4V and 2.5V, respectively.

When the third voltage, e.g., 2.5V is applied to a word line e.g., I7a, all of the N-channel and the P-channel MOSFETs are nonconductive, so that none of these memory cells are accessed. That is, writing into and reading out of the memory cells is not possible but data in the memory cells, e.g., I8a

through l8d and l9a through l9d, is maintained.

When the first voltage is applied to the word line l7a, the N-channel MOSFETs of the memory cells l8a through l8d are made conductive, while the P-channel MOSFETs of the memory cells l9a through l9d are nonconductive, so that the memory cells l8a through l8d incorporating the N-channel MOSFETs are accessed, while the data in the memory cells l9a through l9d is maintained.

When the second voltage is applied to the word line l7a, the P-channel MOSFETs of the memory cells l9a through l9d are made conductive while the N-channel MOSFETs of the memory cells l8a through l8d are nonconductive, so that the memory cells l9a through l9d incorporating the P-channel MOSFETs are accessed while the data in the memory cells l8a through l8d is maintained.

In this way, by selective application of the first, the second or the third voltage to a word line, the row selection circuit 20 selects either the group of N-channel MOSFETs connected to the word line, or the group of P-channel MOSFETS connected to the word line, or does not select any of the N-channel and the P-channel MOSFETs connected to the word line. Since the selection can be made between the group of N-channel MOSFETs and the group of P-channel MOSFETs, each group of the MOSFETs may be considered to form one row, from a viewpoint of selection or selective access, by a row selection circuit 20. Thus, two "rows" of memory cells are consided to be arranged along a single line. These two rows of memory cells are selectively accessed by a single word line, with the use of the three level signal.

It is therefore only necessary for each memory cell to have an adequate area for the passage of a single word line and the area of each memory cell, particularly the area of the flat part can be minimized by enlarging the capacitance Cp on the sidewalls of the trenches l4 to increase the degree of integration.

As mentioned previously, the two rows of the memory cells connected to the same word line are not selected simultaneously. In other words, the N-channel MOSFETs connected to the bit lines l6a through l6d and the P-channel MOSFETs connected to the bit lines l6e through l6h do not conduct simultaneously. Therefore, it can be so arranged that one of the bit lines l6a through l6d to which memory cells having N-channel MOSFETs are connected, and one of the bit lines l6e through l6h to which memory cells having P-channel MOSFETS are connected, are connected to complementary data terminals of a sense amplifier to form a folded-bit line pair. In the illustrated example, the bit line l6a connected to the first (as counted from the top) of the four columns of memory cells having N-channel MOSFETs and the bit line l6e connected to the first (as counted from the top) of the column of memory cells having P-channel MOSFETs are connected to the same sense amplifier l5a to form a bit line pair. Similarly, the second bit lines l6b and l6f are connected to form a bit line pair. Similarly, the third bit lines l6c and l6g form another pair, and the fourth bit lines l6d and l6b form another pair.

In a memory cell array of the folded-bit line configuration, when a memory cell connected to one bit line of a bit line pair is selected, a dummy memory cell connected to the other bit line of the same bit line pair is selected simultaneously, and the potentials on the bit lines are compared and amplified by the sense amplifier. Thus, from the viewpoint of operation of the bit lines, the memory device operates in a manner similar to the operation of the conventional memory device of a folded-bit line configuration. The memory device of the invention differs in the unique arrangement of the rows of the memory cells, and the selective application of three level signal to the word lines, so that each word line can be shared by two rows of memory cells.

In the embodiment described, the n-wells or tubs l3 are formed in the P-type substrate l and the memory cells having N-channel MOSFETs are formed directly on the substrate l, while the memory cells having the P-channel MOSFETs are formed on these n-wells l3. Alternatively, it may be so arranged that p-wells or tubs are formed in an n-type substrate and the memory cells having N-channel MOSFETs are formed on the p-wells, while the memory cells having P-channel MOSFETs are formed directly on the n-type substrate. Still alternatively, the known type of twin-tub configuration may be adopted with the different n and p tubs or wells formed on the same substrate.

## Claims

1.  A semiconductor memory device comprising
    a plurality of memory cells (l8a-l8d, l9a-l9d) arranged in rows and columns (CLa-CLh) to form a matrix,
    a first bit line (l6a) to which memory cells of a first column (CLa) are connected, each of the memory cells of the first column (CLa) comprising an N-channel FET and capacitance means (Cp),
    a second bit line (l6e) to which memory cells of a second column (CLe) are connected, each of the memory cells of the second column comprising a P-channel FET and capacitance means (Cp),
    the first bit line (l6a) and the second bit line (l6e) being connectible to complementary terminals of a sense amplifier (l5a) to form a folded-bit line pair, and

a word line (l7a) for carrying different voltages connected to the gate of the N-channel FET of one of the memory cells of the first column (CLa) and to the gate of the P-channel FET of one of the memory cells of the second column (CLe) to access selective cells dependent on the voltage carried thereby.

2. A device according to claim l, and operably associated with means (20) selectively providing the word line with a first voltage to make conductive the N-channel FET connected thereto and to make nonconductive the P-channel FET connected thereto, or a second voltage to make conductive the P-channel FET connected thereto and to make nonconductive the N-channel FET connected thereto, or a third voltage to make nonconductive both the N-channel FET and the P-channel FET connected thereto.

3. A device according to claim l or 2, wherein a certain number of columns (CLa-CLd) of memory cells having N-channel MOSFETs and the same number of columns (CLe-CLh) of memory cells having P-channel MOSFETs are arranged in alternation.

4. A device according to claim 3, wherein a P-type semiconductor region (l) is formed to span the said certain number of columns with the memory cells having the N-channel MOSFETs and an N-type semiconductor region (l3) is formed to span the said certain number of columns with the memory cells having the P-channel MOSFETs.

5. A device according to claim l, 2 or 3, and composed of a p-type substrate and n-wells with memory cells having N-channel MOSFETs formed directly on the substrate and memory cells having P-channel MOSFETs formed on the n-wells.

6. A device according to claim l, 2 or 3, and composed of an n-type substrate with a p-wells with memory cells having P-channel MOSFETs formed directly on the substrate and memory cells having N-channel MOSFETs formed on the p-well.

7. A device according to claim l, 2 or 3 and composed of a p or n-type substrate with n and p wells formed thereon with some of the cells formed on the n wells and some on the p wells.

8. A device according to any one of claims l to 7, wherein isolation trenches (l4) surround each pair of memory cells sharing a common contact hole (l0).

9. A device according to claim 8, wherein each memory cell has a storage capacitor formed at least partially of a capacitance structure (Cp) on the sidewall of one of the isolation trenches (l4).

10. A device according to any one of claims l to 9, wherein the memory cells are also arranged in lines (LNa-LNd) with each line having the gates of its FETs connected to a respective word line.

**Revendications**

1. Dispositif de mémoire à semiconducteur comprenant :
   - une pluralité de cellules de mémoire (18a-18d, 19a-19d) agencées en rangées et colonnes (CLa-CLh) pour former une matrice ;
   - une première ligne de bits (16a) à laquelle des cellules de mémoire d'une première colonne (CLa) sont reliées, chacune des cellules de mémoire de la première colonne (CLa) comprenant un transistor à effet de champ à canal N et des moyens de capacité (Cp) ;
   - une seconde ligne de bits (16e) à laquelle des cellules de mémoire d'une seconde colonne (Cle) sont reliées, chacune des cellules de mémoire comprenant un transistor à effet de champ à canal P et des moyens de capacité (Cp) ;
   - la première ligne de bits (16a) et la seconde ligne de bits (16e) pouvant être reliées aux bornes complémentaires d'un amplificateur de lecture (15a) pour former une paire de lignes de bits "repliée" ; et
   - une ligne de mots (17a) pour transporter différentes tensions reliée à la grille du transistor à effet de champ à canal N de l'une des cellules de mémoire de la première colonne (CLa) à la grille du transistor à effet de champ à canal P de l'une des cellules de mémoire de la seconde colonne (CLe) pour avoir accès aux cellules sélectives en fonction de la tension transportée par celle-ci.

2. Dispositif suivant la revendication 1 et associé dans son fonctionnement à des moyens (20) fournissant de manière sélective à la ligne de mots une première tension pour rendre conducteur le transistor à effet de champ à canal N relié à celle-ci et pour rendre non conducteur le transistor à effet de champ à canal P relié à celle-ci, ou une seconde tension pour rendre conducteur le transistor à effet de champ à canal p relié à celle-ci et pour rendre non conducteur le transistor à effet de champ à canal N relié à celle-ci ou une troisième tension pour rendre non conducteurs à la fois le transistor à effet de champ à canal N et le transistor à effet de champ à canal P reliés à celle-ci.

3. Dispositif suivant la revendication 1 ou 2, dans lequel un certain nombre de colonnes (CLa-CLd) de cellules de mémoire ayant des transistors à effet de champ MOSFET à canal N et le même nombre de colonnes (CLe-CLh) de cellules de mémoire ayant des transistors à effet de champ MOSFET à canal P sont disposés en alternance.

4. Dispositif suivant la revendication 3, dans lequel une zone de semiconducteur (1) de type P est formée pour accueillir ledit certain nombre de colonnes avec les cellules de mémoire ayant les transistors à effet de champ MOSFET à canal N et une zone de semiconducteur (13) de type N est formée pour accueillir ledit certain nombre de colonnes avec les cellules de mémoire ayant les transistors à effet de champ MOSFET à canal P.

5. Dispositif suivant la revendication 1, 2 ou 3 et composé d'un substrat de type P et de puits n avec des cellules de mémoire ayant des transistors à effet de champ MOSFET à canal N formés directement sur le substrat et des cellules de mémoires ayant des transistors à effet de champ MOSFET à canal P formés sur le puits n.

6. Dispositif suivant la revendication 1, 2 ou 3, et composé d'un substrat de type n avec des puits p avec des cellules de mémoires ayant des transistors à effet de champ MOSFET à canal P formés directement sur le substrat et des cellules de mémoires ayant des transistors à effet de champ MOSFET à canal N formés sur les puits P.

7. Dispositif suivant la revendication 1, 2 ou 3 et composé d'un substrat de type p ou n avec des puits n ou p formés sur celui-ci avec quelques cellules formées sur les puits n et quelques unes sur les puits p.

8. Dispositif suivant l'une quelconque des revendications 1 à 7, dans laquelle des tranchées d'isolation (14) entourent chaque paire de cellules partageant un trou de contact commun (10).

9. Dispositif suivant la revendication 8, dans lequel chaque cellule de mémoire possède un condensateur de stockage formé au moins partiellement d'une structure de capacité (Cp) sur la paroi latérale de l'une des tranchées d'isolation (14).

10. Dispositif suivant l'une quelconque des revendications 1 à 9, dans lequel les cellules de mémoire sont également agencées en lignes (LNa à LNd) chaque ligne ayant les grilles de ses transistors à effet de champ reliées à une ligne de mots respective.

**Patentansprüche**

1. Halbleiterspeicheranordnung, welche aufweist eine Vielzahl von in Reihen und Spalten (CLa-CLh) zur Bildung einer Matrix angeordneten Speicherzellen (18a-18d, 19a-19d), eine erste Bitleitung (16a), mit der Speicherzellen einer ersten Spalte (CLa) verbunden sind, wobei jede der Speicherzellen der ersten Spalte (CLa) einen N-Kanal-FET und eine Kapazität (Cp) aufweist, eine zweite Bitleitung (16e), mit der Speicherzellen einer zweiten Spalte (CLe) verbunden sind, wobei jede der Speicherzellen der zweiten Spalte einen P-Kanal-FET und eine Kapazität (Cp) aufweist, und wobei die erste Bitleitung (16a) und die zweite Bitleitung (16e) mit komplementären Anschlüssen eines Leseverstärkers (15a) verbindbar sind zur Bildung eines Falt-Bitleitungspaares, und eine Wortleitung (17a) zur Übertragung unterschiedlicher Spannungen, die mit dem Gate des N-Kanal-FETs einer der Speicherzellen der ersten Spalte (CLa) und mit dem Gate des P-Kanal-FETs einer der Speicherzellen der zweiten Spalte (CLe) verbunden ist zum Zugriff auf selektive Zellen abhängig von der übertragenen Spannung.

2. Anordnung nach Anspruch 1, die betriebsmäßig Mitteln (20) zugeordnet ist, welche selektiv die Wortleitung mit einer ersten Spannung, um den mit dieser verbundenen N-Kanal-FET in den leitenden Zustand und den mit dieser verbundenen P-Kanal-FET in den nichtleitenden Zustand zu bringen, oder mit einer zweiten Spannung, um den mit dieser verbundenen P-Kanal-FET in den leitenden Zustand und den mit dieser verbundenen N-Kanal-FET in den nichtleitenden Zustand zu bringen, oder mit einer dritten Spannung, um sowohl den mit ihr verbundenen N-Kanal-FET als auch den mit ihr verbundenen P-Kanal-FET in den nichtleitenden Zustand zu bringen, versorgt.

3. Anordnung nach Anspruch 1 oder 2, worin eine gewisse Anzahl von Spalten (CLa-CLd) von Speicherzellen, die N-Kanal-MOSFETS aufweisen, und die gleiche Anzahl von Spalten (CLe-CLh) von Speicherzellen, die P-Kanal-MOSFETs aufweisen, einander abwechselnd angeordnet sind.

4. Anordnung nach Anspruch 3, worin ein P-Typ-Halbleiterbereich (1) gebildet ist, um sich über die gewisse Anzahl von Spalten mit den N-Kanal-MOSFETS aufweisenden Speicherzellen zu erstrecken, und ein N-Typ-Halbleiterbereich (13) gebildet ist, um sich über die gewisse Anzahl von Spalten mit den P-Kanal-MOSFETS aufweisenden Speicherzellen zu erstrecken.

5. Anordnung nach Anspruch 1, 2 oder 3, die aus einem p-Typ-Substrat und eingelassenen n-Bereichen zusammengesetzt ist, mit N-Kanal-MOSFETS aufweisenden Speicherzellen, die direkt auf dem Substrat gebildet sind, und mit P-Kanal-MOSFETS aufweisenden Speicherzellen, die auf den n-Bereichen gebildet sind.

6. Anordnung nach Anspruch 1, 2 oder 3, die aus einem n-Typ-Substrat mit eingelassenen p-Bereichen besteht, mit P-Kanal-MOSFETS aufweisenden Speicherzellen, die direkt auf dem Substrat gebildet sind, und mit N-Kanal-MOSFETs aufweisenden Speicherzellen, die auf den p-Bereichen gebildet sind.

7. Anordnung nach Anspruch 1, 2 oder 3, die aus einem p- oder n-Typ-Substrat mit darin eingelassenen n- und p-Bereichen besteht, wobei einige der Zellen auf den n-Bereichen und einige der Zellen auf den p-Bereichen gebildet sind.

8. Anordnung nach einem der Ansprüche 1 bis 7, worin Isolationsgräben (14) jedes Paar von Speicherzellen, die sich ein gemeinsames Kontaktloch (10) teilen, umgeben.

9. Anordnung nach Anspruch 8, worin jede Speicherzelle einen Speicherkondensator aufweist, der wenigstens teilweise aus einer Kapazitätsstruktur (Cp) auf der Seitenwand eines der Isolationsgräben (14) gebildet ist.

10. Anordnung nach einem der Ansprüche 1 bis 9, worin die Speicherzellen auch in Zeilen (LNa-LNd) angeordnet sind, wobei die Gates der FETs jeder Zeile mit einer jeweiligen Wortleitung verbunden sind.

FIG.1A PRIOR ART

FIG.1B PRIOR ART

F I G. 2

FIG. 3